# FASCICULE DE BREVET EUROPEEN

(11) **EP 0 851 464 B1**
(45) Date de publication et mention de la délivrance du brevet: **21.04.2010**
(21) Numéro de dépôt: 97403107.2
(22) Date de dépôt: 22.12.1997
(51) Int. Cl.: H01L 21/027

(54) **Traitement anti-reflet de surfaces réflectives**
Anti-reflektierende Behandlung von reflektierenden Oberflächen
Anti-reflective treatment of reflecting surfaces

(30) Priorité: 27.12.1996 FR 9616106
(43) Date de publication de la demande: 01.07.1998
(73) Titulaire: Chartoleaux KG Limited Liability Company, Wilmington, DE 19808 (US)
(72) Inventeur: Francou, Jean-Marc, 38240 Meylan (FR); Halimaoui, Aomar, 38100 Grenoble (FR); Schiltz, André, 38330 Saint-Ismier (FR)
(74) Mandataire: Loisel, Bertrand

(56) Documents cités:
- DE-A- 4 320 033
- US-A- 5 139 974
- MENNA P ET AL: "POROUS SILICON IN SOLAR CELLS: A REVIEW AND A DESCRIPTION OF ITS APPLICATION AS AN AR COATING" SOLAR ENERGY MATERIALS AND SOLAR CELLS, vol. 37, no. 1, 1 avril 1995, pages 13-24, XP000517030

## Description

La présente invention a trait aux techniques photolithographiques utilisées dans la fabrication de circuits intégrés et, plus particulièrement, aux techniques de lithographie optique de haute résolution. Elle concerne plus particulièrement les techniques réduisant les effets néfastes de la réflexion des ondes optiques sur la couche sous-jacente à une résine photosensible.

Dans les étapes de fabrication d'un circuit intégré, des couches de matériaux semi-conducteurs ou des couches métalliques doivent être lithographiées. Ces couches peuvent être de topographies variables, planes ou en relief. De façon conventionnelle, la lithographie s'effectue par dépôt d'une résine photosensible sur cette couche à lithographier dont on ne sensibilise que certaines zones désirées qui seront ensuite développées dans un développeur approprié à la nature chimique de la résine, révélant ainsi des zones spécifiques de la couche à lithographier.

Cette technique est par exemple utilisée pour définir le niveau de la grille d'un transistor MOS dans une couche de silicium polycristallin. Les dimensions des grilles d'un transistor sont si réduites que les moindres insolations parasites sont nuisibles et sont rédhibitoires pour le transistor. Ces insolations parasites sont notamment générées par la réflexion d'une lumière incidente sur la couche à lithographier sous-jacente à la résine, augmentant les effets d'interférence dans la résine et la diffusion de la lumière sur les variations topologiques. De tels effets deviennent de moins en moins tolérables du fait des dimensions caractéristiques des technologies submicroniques.

Une approche pour réduire l'influence de la lumière réfléchie dans les techniques de photolithographie consiste à déposer directement sur la surface réflective une couche anti-reflet dite ARC (anti-reflective coating), qui peut être soit minérale, soit organique. La résine photosensible est ensuite déposée directement sur la couche d'ARC.

Le document DE-A-4 320 033 décrit un tel procédé utilisant une couche minérale.

Cependant, l'utilisation de ces ARC nécessite un dépôt séparé ainsi que des recuits appropriés à ces matériaux. Hormis la lourdeur des équipements supplémentaires nécessaires pour mettre en oeuvre ces techniques d'étalement, il faut ajouter les précautions à prendre pour le contrôle de tous les paramètres du procédé de dépôt de ces couches (temps de recuit, minimisation de la défectivité, etc...).

Outre ces problèmes de mise en oeuvre du procédé, les ARC ne présentent pas les propriétés escomptées.

Bien qu'ils possèdent de bonnes propriétés anti-réflectives, les ARC organiques présentent des problèmes de variation d'épaisseur de couches dus en particulier à la topographie de la surface sur laquelle ils sont déposés. Ces problèmes sont en effet directement liés aux effet de planarisation du dépôt. L'épaisseur de l'ARC n'étant pas la même sur toute la surface, on a un risque de surgravure latérale dans les zones où l'ARC est moins épais lors de la gravure de l'ARC par plasma spécifique.

En ce qui concerne les ARC minéraux, ils nécessitent des mises au point et étapes supplémentaires au procédé de photolithographie, notamment un ajustement de leur indice de réfraction n et de leur coefficient d'extinction k en fonction des épaisseurs déposées, une gravure spécifique après insolation et développement de la résine photosensible, et leur élimination après photogravure dans une étape supplémentaire. Ils ont par contre l'avantage sur les ARC organiques de présenter des dépôts conformes.

Une autre approche pour réduire la réflexion de la lumière incidente sur une couche réfléchissante dans une étape de photolithogravure est décrite dans le brevet US-A-5 139 974. Cette approche consiste à augmenter la rugosité d'une surface métallique réflective afin d'augmenter l'absorption de la lumière incidente. Cependant, l'augmentation de la rugosité de la surface est mise en oeuvre par un procédé qui ne garantit pas une uniformité de l'état physique de la surface, phénomène d'autant plus accentué que la couche à traiter comporte des motifs et présente donc une surface en relief. Cette technique ne permet de modifier les propriétés optiques du matériau que de manière aléatoire difficilement reproductible.

Un but de l'invention est l'amélioration de l'étape de photolithographie dans la fabrication des circuits intégrés.

Un autre but de l'invention consiste à atténuer, voire de supprimer les effets néfastes dus à la réflexion de la lumière incidente sur une couche réflective lors de l'insolation d'une résine photosensible, tout en surmontant les inconvénients liés aux solutions de l'art antérieur.

Les inventeurs ont mis en évidence que la formation d'une couche poreuse au sein même du matériau à lithographier, et en surface de celui-ci de manière à ce que cette nouvelle couche poreuse soit située entre la couche de matériau à lithographier et la résine photosensible, permet de réduire de façon considérable et ce jusqu'à plus de 95% la réflectivité de la couche à lithographier; et ce de manière stable et reproductible. En outre, les propriétés optiques de la couche absorbante poreuse sont maîtrisables afin d'obtenir la réflectivité désirée.

Ainsi, l'invention propose un procédé de photolithographie amélioré dans la fabrication de circuits intégrés dont la caractéristique principale est que l'on forme, préalablement au dépôt de la résine photosensible, au sein du matériau à lithographier et en surface de celui-ci, une couche de ce même matériau poreux d'épaisseur donnée.

Le matériau de la couche à lithographier, sous-jacente à la résine photosensible et au sein de laquelle la couche poreuse est formée, est composé d'un matériau conducteur ou d'un matériau semi-conducteur. Selon un aspect du procédé de l'invention, le matériau est un matériau silicié susceptible de former du silicium poreux. Ce matériau silicié peut présenter différentes structures cristallographiques, par exemple il peut s'agir de silicium amorphe, silicium polycristallin, silicium monocristallin.

La porosité et l'épaisseur de la couche de matériau poreux formée au sein de la couche à lithographier sont déterminées en fonction des propriétés optiques visées (indice de réfraction et coefficent d'extinction de la couche de matériau poreux) ou encore de la réflectivité désirée pour une longueur d'onde donnée. L'épaisseur de la couche de matériau poreux est typiquement comprise entre 200 et 800 Å (1Å = 0.1 nm).

La formation de la couche de matériau poreux au sein de la couche à lithographier peut être réalisée par voie chimique, électrochimique, par plasma ou toute autre façon susceptible de fabriquer du matériau poreux à partir du matériau de la couche à lithographier. Par voie chimique, méthode préférée dans le cadre de l'invention, la porosité et l'épaisseur de la couche poreuse sont ajustées par variation d'au moins le temps de traitement, ou d'au moins les propriétés du bain chimique.

Selon une mise en oeuvre préférentielle de l'invention, une couche de silicium poreux est formée par voie chimique en surface d'une couche d'un matériau silicié.

Selon le procédé de l'invention, on procède ensuite au dépôt et à l'insolation à une longueur d'onde donnée de la résine photosensible. On utilise de façon courante pour l'insolation une lampe à UV comme source. L'insolation de la résine photosensible peut s'effectuer à une longueur d'onde variant entre 193 et 500 nm. Le procédé de l'invention est particulièrement adapté aux techniques de lithographie optiques de haute résolution utilisant une longueur d'onde courte de l'UV, dit Deep-UV, comprise entre 200 et 300 nm, ainsi que les raies g, h et i du spectre du mercure. Toutefois, ces domaines n'exluent pas des longueurs d'ondes plus courtes, susceptibles de sensibiliser une résine et d'être absorbées par la couche poreuse.

Selon le procédé de l'invention, on développe ensuite la résine, on grave le matériau de la couche sous-jacente à la résine à lithographier. Cette étape de gravure plasma, conventionnelle pour graver le matériau de la couche à lithographier, présente l'avantage selon le procédé de l'invention de ne pas nécessiter une gravure plasma supplémentaire spécifique pour graver la couche anti-réflective que constitue la couche de matériau poreux formée précédemment. Ainsi, si la couche n'est pas ôtée pendant le développement de la résine, elle sera gravée pendant la phase de gravure de la couche à lithographier sans mesure particulière.

L'étape suivante concerne le retrait de la résine de manière conventionnelle. La couche dc matériau poreux qui est restée sous les parties de la résine constituant le masque de gravure de la couche à lithographier, peut aisément êtrc éliminée par trempage dans une solution basique.

Le procédé de l'invention peut aisément être mis en oeuvre dans différentes technologies de fabrication, telles que les technologies MOS, BIPOLAIRE, BICMOS, etc...

Selon une mise en oeuvre préférentielle de l'invention, on utilisera le procédé de photolithographie amélioré et particulièrement adapté à la gravure de la grille en polysilicium d'un transistor MOS, qui présente des dimensions très réduites et pour lesquelles les moindres insolations parasites sont nuisibles pour le transistor.

D'autres avantages et caractéristiques de l'invention apparaîtront à l'examen de la description détaillée des modes de mise en oeuvre et de réalisation de l'invention, nullement limitatifs et à la lecture des dessins sur lesquels :

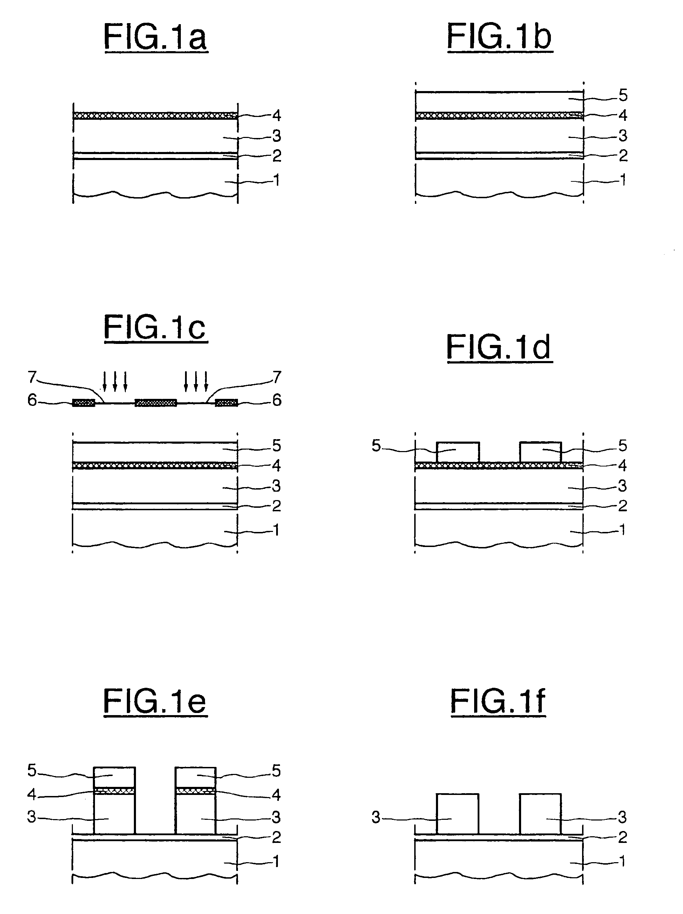

les figures 1a à 1f illustrent de manière schématique les étapes du procédé de photolithographie de l'invention.

Selon un mode de réalisation de l'invention, la couche de matériau à lithographier est à base de silicium susceptible de former du silicium poreux. Pour simplifier la description détaillée du procédé de l'invention, celle-ci sera faite par rapport à ce mode de réalisation particulier du procédé de l'invention. Il est bien entendu que la couche à lithographier peut également être constituée d'un autre matériau semi-conducteur ou d'un matériau conducteur.

Tel qu'illustré sur les figures 1a à 1f, la mise en oeuvre du procédé de l'invention comporte en premier lieu la formation au sein d'une couche à lithographier 3 et en surface de celle-ci une couche poreuse 4 du même matériau que la couche 3 sous-jacente. Cette couche poreuse 4 constitue la couche anti-réflective du procédé de photolithographie, et cette première étape constitue une des caractéristiques essentielles du procédé de l'invention. La formation de cette couche 4 de silicium poreux peut être réalisée à partir d'une surface de silicium polycristallin, monocristallin ou amorphe, recuit ou non recuit, etc... La formation de la couche de silicium poreux peut s'effectuer selon le procédé de l'invention par voie chimique, électrochimique, par plasma ou tout autre procédé susceptible de fabriquer du silicium poreux à partir d'une surface siliciée.

Selon un mode de réalisation préférentiel de l'invention, la couche de silicium poreux est réalisée par voie chimique utilisant un bain comprenant un mélange d'acide fluorhydrique et d'un agent oxydant tel que l'acide nitrique en solution aqueuse. L'utilisation d'un tensio-actif tel que l'acide acétique ou, de préférence, d'un tensio-actif de type silicone, permet d'améliorer les propriétés de mouillage du bain et donc l'homogénéité de la couche poreuse.

Un avantage du procédé de l'invention et particulièrement du traitement par voie chimique, est l'utilisation d'un traitement simple nécessitant un équipement simple et peu onéreux. En outre, la couche poreuse ainsi formée est conforme, s'affranchissant ainsi de tous les problèmes liés au dépôt non conforme des ARC organiques utilisés jusqu'à présent tels que les problèmes de surgravure ou de variation de la réflectivité avec la topographie de la surface.

L'épaisseur et la porosité de la couche sont ajustées en faisant varier le temps de traitement, tel que le trempage dans le bain chimique, et/ou les propriétés du bain chimique, tel que sa composition et sa température. L'ajustement de la porosité et de l'épaisseur est faite en fonction des propriétés optiques désirées, notamment l'indice de réfraction n et le coefficient d'extinction k de la couche anti-réflective, ou encore de la réflectivité désirée à une longueur d'onde d'insolation de la résine donnée. Pour obtenir de bonnes performances, la réflectivité est de préférence inférieure à 5%.

On obtient le dispositif illustré à la figure la, sur laquelle sur un substrat semi-conducteur en silicium 1 recouvert d'une couche d'oxyde primaire 2, on a déposé une couche siliciée 3, notamment en polysilicium, silicium amorphe ou silicium mono-cristallin, au sein et en surface de laquelle a été formée selon le procédé de l'invention une fine couche 4 de silicium poreux d'épaisseur comprise typiquement entre 200 et 800 Å.

Selon le procédé de l'invention, on dépose ensuite sur cette couche poreuse 4 une couche 5 de résine photosensible à une longueur d'onde donnée par des méthodes conventionnelles, telles que le dépôt par tournette, par piste d'étalement, etc... Cette étape est illustrée à la figure 1b.

Selon le procédé de l'invention, l'étape suivante consiste en l'insolation de la résine photosensible en vue de former un masque pour la gravure de la couche de silicium sous-jacente. L'insolation s'effectue à une longueur d'onde donnée. La présence de la couche poreuse anti-réflective rend le procédé de l'invention plus particulièrement approprié aux techniques de lithographie optiques de haute résolution, utilisant les raies g, h et i du spectre du mercure et le Deep UV, ultraviolet à longueur courte, comprise entre 200 et 300 nm. On utilise plus particulièrement des longueurs d'onde conventionnelles comprises entre 193 et 436 nm.

Selon le procédé de l'invention, on observe une diminution significative de la réflectivité jusqu'à plus de 95% en utilisant une couche poreuse comme couche anti-réflective. Dans le tableau ci-dessous, sont reportés les résultats comparatifs des mesures de réflectivité sur un échantillon comportant une couche de silicium poreux par rapport à un échantillon non traité dont la couche sous-jacente à la résine est une couche de silicium polycristallin.

| λ | Epaisseur indicative de silicium poreux | Réflectivité mesurée sur l'échantillon traité | Réflectivité de référence mesurée sur Si polycristallin non traité |
|---|---|---|---|
| 248 nm | 350 Å | 10,5 % | 63,3 % |
| | 500 Å | 5 % | |
| | 700 Å | 2,5 % | |
| | | | |
| 365 nm | 350 Å | 14 % | 55,5 % |
| | 500 Å | 9,5 % | |
| | 700 Å | 2 % | |

Les variations des indices de réfraction et coefficients d'extinction correspondant aux échantillons ci-dessus sont les suivantes :
pour λ = 248 nm : n = 1,6 et k = 0,4 à 0,8
pour λ = 365 nm : n = 1,6 et k = 0,4 à 0,8

Dans le cadre de la gravure de la grille d'un transistor MOS qui présente des dimensions très réduites, on n'observe aucune insolation parasite qui pourrait être nuisible ou rédhibitoire pour le transistor fabriqué.

Cette étape d'insolation de la résine est illustrée à la figure 1c, sur laquelle la radiation optique représentée par des flèches est incidente sur un masque 6. La radiation optique passe au travers des zones non masquées 7 pour exposer les portions de résine 5 sous-jacentes à ces zones 7 créant ainsi une image latente dans la résine. Un tel procédé est conventionnel.

Après exposition de la résine, les portions de résine insolées sont développées dans un bain développeur conventionnel pour éliminer par dissolution les parties insolées de la résine s'il s'agit d'une résine dite résist positif ou les parties non-insolées s'il s'agit d'une résine dite résist négatif. La figure 1d illustre le cas d'une résine négative. Le substrat de silicium 1 recouvert de la couche d'oxyde primaire 2 est surmonté de la couche siliciée 3 dont la surface a été transformée en une couche poreuse 4 sur une épaisseur donnée. La résine 5 forme un masque sur ladite couche poreuse 4 en vue de la gravure du silicium de la couche 3.

Le silicium de la couche 3 est ensuite gravé par plasma de manière conventionnelle. Cette gravure plasma permet de graver la couche de silicium 3, qu'il reste ou non en surface des zones non masquées du silicium poreux. Si la couche de silicium poreux 4 n'est pas ôtée pendant le développement de la résine 5, elle sera gravée sans mesure particulière pendant la phase de gravure de la couche de silicium 3. L'existence de cette couche 4 de matériau poreux anti-réflective ne nécessite donc pas une gravure plasma supplémentaire de ladite couche 4. Ceci constitue un autre avantage du procédé de l'invention. La figure 1d illustre le dispositif ainsi réalisé dans lequel le substrat de silicium 1 recouvert de la couche d'oxyde primaire 2 est surmonté de motifs 3 en silicium, quelle que soit sa structure cristallographique, lesquels motifs sont recouverts d'une couche 4 de silicium poreux surmontée du masque en résine 5.

On retire ensuite la résine de manière conventionnelle.

La couche de silicium poreux 4 qui rcstait sous les parties de la résine 5 insolées ou non insolées suivant que la résine utilisée était négative ou positive, peut aisément être éliminée par trempage dans une solution basique. On obtient alors le dispositif illustré à la figure 1f, sur laquelle le substrat de silicium 1 recouvert de la couche d'oxyde primaire 2, est surmonté de motifs en silicium 3.

Le procédé de l'invention peut être mis en oeuvre dans de nombreuses technologies de fabrication, telles que les technologies MOS, BIPOLAIRE, BICMOS, etc... Il peut être avantageusement utilisé pour la photolithographie de motifs de dimensions très réduites, tels que par exemple la gravure de la grille d'un transistor MOS, car la réduction significative de la réflexion de l'onde optique incidente sur la couche à lithographier réduit également considérablement les insolations parasites générant des défauts morphologiques nuisibles à la fabrication par exemple de transistors.

## Revendications

1. Procédé de photolithographie d'une couche sous-jacente à une couche de résine photosensible dans la fabrication de circuits intégrés, comprenant les étapes de dépôt, d'insolation à une longueur d'onde donnée et de développement de la résine photosensible, suivies de la gravure de la couche à lithographier et du retrait de la résine, **caractérisé en ce que** préalablement au dépôt de la résine photosensible, on forme au sein de la couche à lithographier et en surface de celle-ci une couche poreuse anti-reflet et du même matériau d'épaisseur donnée.

2. Procédé selon la revendication 1, **caractérisé en ce que** le matériau de la couche à lithographier est un matériau conducteur ou semi conducteur.

3. Procédé selon la revendication 2, **caractérisé en ce que** le matériau de la couche à lithographier est un matériau semi-conducteur silicié susceptible de former du silicium poreux.

4. Procédé selon l'une quelconque des revendications 1 à 3, **caractérisé en ce que** la porosité et l'épaisseur de la couche de matériau poreux formée au sein de la couche à lithographier sont déterminées en fonction des propriétés optiques visées ou due la réflectivité recherchée.

5. Procédé selon à revendication 4, **caractérisé en ce que** l'épaisseur de la couche du matériau poreux est comprise typiquement entre 20 et 80 nm (200 et 800 Å).

6. Procédé selon l'une quelconque des revendications 1 à 5, **caractérisé en ce que** la couche de matériau poreux est formée par voie chimique.

7. Procédé selon la revendication 6, **caractérisé en ce que** la porosité et l'épaisseur de la couche de matériau poreux formée par voie chimique au sein de la couche à lithographier, sont ajustées par variation d'au moins un des paramètres suivants :
a) temps de traitement pour former la couche de matériau poreux, et
b) propriétés du bain chimique.

8. Procédé selon la revendication 7, **caractérisé en ce que** le bain chimique comprend un tensio-actif de type silicone.

9. Procèdé selon l'une quelconque des revendications 1 à 8, **caractérisé en ce que** la longueur d'onde à laquelle la résine photosensible est insole est comprise dans le domaine Deep UV ou correspond aux raies g, h et i du spectre du mercure.

10. Procédé selon l'une quelconque des revendication 1 à 9, pour la gravure de la grille en polysilicium d'un transistor MOS.

## Claims

1. Process for photolithographically patterning a layer subjacent to a layer of photosensitive resin in the fabrication of integrated circuits, comprising the steps of deposition, exposure to a given wavelength and development of the photosensitive resin, followed by the etching of the layer to be lithographically patterned and the removal of the resin, **characterised in that**, prior to deposition of the photosensitive resin, a porous layer is formed within the layer to be lithographically patterned and on the surface thereof, this porous layer being antireflective and of the same material and having a given thickness.

2. Process according to claim 1, **characterised in that** the material of the layer to be lithographically patterned is a conductive material or a semiconductor material.

3. Process according to claim 2, **characterised in that** the material of the layer to be lithographically patterned is a silicon-based semiconductor material capable of forming porous silicon.

4. Process according to any one of claims 1 to 3, **characterised in that** the porosity and the thickness of the layer of porous material formed within the layer to be lithographically patterned are determined depending on the intended optical properties or on the desired reflectivity.

5. Process according to claim 4, **characterised in that** the thickness of the layer of porous material is typically between 20 and 80 nm (200 and 800 Å).

6. Process according to any one of claims 1 to 5, **characterised in that** the layer of porous material is formed by a chemical method.

7. Process according to claim 6, **characterised in that** the porosity and the thickness of the layer of porous material formed by a chemical method within the layer to be lithographically patterned are adjusted by varying at least one of the following parameters:
a) the treatment time for forming the layer of porous material; and
b) the properties of the chemical bath.

8. Process according to claim 7, **characterised in that** the chemical bath contains a silicone-type surfactant.

9. Process according to one of claims 1 to 8, **characterised in that** the wavelength to which the photosensitive resin is exposed lies within the deep UV range or corresponds to the g, h and i lines of the spectrum of mercury.

10. Process according to any one of claims 1 to 9 for etching the polysilicon gate of an MOS transistor.

## Patentansprüche

1. Verfahren zur Photolithographie einer unter einer lichtempfindlichen Harzschicht vorhandenen Schicht bei der Fertigung integrierter Schaltungen, mit den Schritten des Ablagerns, des Bestrahlens mit einer gegebenen Wellenlänge und des Entwickelns des lichtempfindlichen Harzes, gefolgt vom Ätzen der zu lithographierenden Schicht und des Entfernens des Harzes, **dadurch gekennzeichnet, dass** vor der Ablagerung des lichtempfindlichen Harzes innerhalb der zu lithographierenden Schicht und auf deren Oberfläche eine entspiegelnde, poröse Schicht aus demselben Material mit gegebener Dicke gebildet wird.

2. Verfahren nach Anspruch 1, **dadurch gekennzeichnet, dass** das Material der zu lithographierenden Schicht ein Leitermaterial oder ein Halbleitermaterial ist.

3. Verfahren nach Anspruch 2, **dadurch gekennzeichnet, dass** das Material der zu lithographierenden Schicht ein siliziertes Halbleitermaterial ist, das poröses Silizium bilden kann.

4. Verfahren nach einem der Ansprüche 1 bis 3, **dadurch gekennzeichnet, dass** die Porosität und die Dicke der Schicht aus porösem Material, die innerhalb der zu lithographierenden Schicht gebildet wird, in Abhängigkeit von angestrebten optischen Eigenschaften oder von dem gewünschten Reflexionsvermögen bestimmt werden.

5. Verfahren nach Anspruch 4, **dadurch gekennzeichnet, dass** die Dicke der Schicht des porösen Materials typischerweise im Bereich von 20 bis 80 nm (200 bis 800 Å) liegt.

6. Verfahren nach einem der Ansprüche 1 bis 5, **dadurch gekennzeichnet, dass** die Schicht aus porösem Material auf chemischem Weg gebildet wird.

7. Verfahren nach Anspruch 6, **dadurch gekennzeichnet, dass** die Porosität und die Dicke der Schicht aus porösem Material, die auf chemischem Weg innerhalb der zu lithographierenden Schicht gebildet wird, durch Verändern wenigstens eines der folgenden Parameter eingestellt werden:
a) Behandlungsdauer zum Bilden der Schicht aus porösem Material und
b) Eigenschaften des chemischen Bades.

8. Verfahren nach Anspruch 7, **dadurch gekennzeichnet, dass** das chemische Bad ein Tensid des Silikon-Typs enthält.

9. Verfahren nach einem der Ansprüche 1 bis 8, **dadurch gekennzeichnet, dass** die Wellenlänge, mit der das lichtempfindliche Harz bestrahlt wird, im Bereich des tiefen Ultraviolett liegt oder den g-, h- und i-Linien des Quecksilberspektrums entspricht.

10. Verfahren nach einem der Ansprüche 1 bis 9 zum Ätzen des Polysilizium-Gates eines MOS-Transistors.
